## Europäisches Patentamt

## European Patent Office

## Office européen des brevets

(19)

(11) Veröffentlichungsnummer: **0 001 550**
**B1**

(12)

# EUROPÄISCHE PATENTSCHRIFT

(45) Veröffentlichungstag der Patentschrift:
07.10.81

(51) Int. Cl.³: **H 01 L 21/70,** H 01 L 23/48

(21) Anmeldenummer: **78100830.5**

(22) Anmeldetag: **06.09.78**

(54) **Integrierte Halbleiteranordnung für eine Bauelementstruktur mit kleinen Abmessungen und zugehöriges Herstellungsvefahren.**

(30) Priorität: **25.10.77 US 844769**

(43) Veröffentlichungstag der Anmeldung:
**02.05.79 Patentblatt 79/9**

(45) Bekanntmachung des Hinweises auf die Patenterteilung:
**07.10.81 Patentblatt 81/40**

(84) Benannte Vertragsstaaten:
**BE CH DE FR GB NL SE**

(56) Entgegenhaltungen:
**DE-A-2 365 056**
**DE-A-2 633 714**
**IBM Technical Disclosure Bulletin,**
**vol. 19, no. 12, May 1977,**
**Armonk, New York, USA,**
**C.G. JAMBOTKAR: "Method for reducing**
**the emitter-base contact distance in**
**bipolar transistors"**

(73) Patentinhaber: **International Business Machines Corporation, Armonk, N.Y. 10504 (US)**

(72) Erfinder: **Anantha, Narasipur Gundappa, 1 Valdemar Road, Hopewell Junction New York 12533 (US)**
Erfinder: **Bhatia, Harsaran Singh, 41 Tor Road, Wappingers Falls New York 12590 (US)**
Erfinder: **Walsh, James Leo, 23 South Drive, Hyde Park New York 12538 (US)**

(74) Vertreter: **Oechssler, Dietrich Dr. rer. nat., Schönaicher Strasse 220, D-7030 Böblingen (DE)**

## Integrierte Halbleiteranordnung für eine Bauelementstruktur mit kleinen Abmessungen und zugehöriges Herstellungsverfahren

Die Erfindung bezieht sich auf eine integrierte Halbleiteranordnung für eine Bauelementstruktur mit kleinem Basiskontakt-Emitterkontaktabstand der im Oberbegriff des Patentanspruchs 1 angegebenen Art sowie auf ein zugehöriges Verfahren zu deren Herstellung.

Eine Halbleiteranordnung der im Oberbegriff angegebenen Art ist aus der Veröffentlichung in IBM-TDB, Bd. 19, Nr. 12, Mai 1977, S. 4601–4604 bekannt.

In der monolithisch integrierten Schaltkreistechnik besteht im allgemeinen die Notwendigkeit, die verschiedenen aktiven und passiven Bauelemente voneinander im Rahmen der integrierten Schaltung zu isolieren. Als mögliche Isolationstechniken kommen dafür die sog. aktive Isolation mittels gesperrter PN-Übergänge sowie die teilweise oder vollständige sog. passive bzw. dielektrische Isolation in Frage. Die zugehörigen dielektrischen Materialien waren dabei Siliciumdioxid, Glas usw. Bevorzugt wird im Rahmen der hochintegrierten Schaltungstechnik die dielektrische Isolation. Vorteilhaft ist dabei im wesentlichen gegenüber der aktiven Isolation, dass die Dotierungsgebiete der jeweiligen Schaltelemente direkt an die Isolationsgebiete anstossen können, was in einer grösseren Packungsdichte resultiert. In jedem Fall liegen demnach nach Vorsehung der Isolation gegeneinander isolierte Siliciumbereiche im Halbleiterkörper vor.

In diesen einkristallinen isolierten Siliciumbereichen werden dann aktive Schaltelemente, z.B. Bipolartransistoren, Feldeffekttransistoren sowie passive Bauelemente, z.B. Widerstände, Dioden usw., hergestellt. Die wesentlichen Schritte im Rahmen der Herstellung derartiger integrierter Schaltungsbauelemente können als allgemeiner Stand der Technik vorausgesetzt werden. An dieser Stelle wird deshalb nur eine kurze Übersichtsdarstellung dazu gegeben.

Man geht beispielsweise von einem P-leitenden Siliciumsubstrat aus, oxidiert dessen Oberfläche, öffnet in der Oxidschicht mittels konventioneller Photolithographie- und Ätzverfahren Maskenfenster für die anschliessende Eindotierung, z.B. Diffusion, eines N+-leitenden vergrabenen Bereichs, der später den Subkollektor darstellen wird. Anschliessend wird die Siliciumdioxidschicht entfernt und man lässt eine Epitaxieschicht aus N-leitendem Silicium auf der freigelegten Halbleiteroberfläche aufwachsen. Während des Wachstums der Epitaxieschicht erfolgt eine gewisse Ausdiffusion des vergrabenen Bereiches in die Epitaxieschicht hinein. Auf die Oberfläche der so gebildeten Epitaxieschicht wird dann erneut eine Siliciumdioxidschicht aufgebracht, in der wiederum Maskenöffnungen für die Isolationsdiffusion bzw. die dielektrischen Isolationsgebiete hergestellt werden. Nach deren Herstellung werden erneut Dotierungsöffnungen in der Siliciumdioxidschicht für die Basisdotierung geöffnet, was im Falle eines NPN-Transistors oder eines Widerstandsbereiches durch Eindotierung von P-leitenden Dotierungsstoffen in die Epitaxieschicht erfolgt. Die Halbleiteroberfläche wird danach jeweils reoxidiert, worauf anschliessend in gleicher Weise die Verfahrensschritte zur Ausbildung der Emitter sowie der Kollektoranschlussgebiete durchgeführt werden. Daran schliessen sich die Ausbildung der ohmschen Anschlusskontakte sowie der Metallisierung für die Verbindungsleiterzüge an, die beispielsweise aus Aluminium hergestellt werden.

Für den ohmschen Kontakt zu Halbleitergebieten sowie als Ersatz für metallische Schaltkreisverbindungen sind auch bereits polykristalline Siliciumschichten beschrieben worden, vgl. z.B. US-Patentschriften 3 664 896 und 3 978 515. In diesem Zusammenhang wird weiter verwiesen auf 1977 IEEE International Solid-State Circuits Conference, Digest of Technical Papers, Seiten 196/197 sowie auf die Veröffentlichung im IBM Technical Disclosure Bulletin, Band 19, Nr. 12, Mai 1977, Seiten 4601 ff.

Es ist bekannt, dass bestimmte Betriebseigenschaften, wie die Schaltgeschwindigkeit, bei einem Bipolartransistor abhängig sind vom Abstand zwischen den Emitter- und Basiskontakten. Dieser Abstand wird im allgemeinen durch den jeweils erreichten technologischen Stand auf dem Gebiet der Photolithographie bestimmt sein. Aufgrund dieser durch die Photolithographie bestimmten Beschränkungen sowie des jeweils einzuhaltenden Mindest-Linienabstandes ergibt sich für den genannten Abstand bei üblicher Photolithographie ein Wert von typisch 4 bis 6 μm. Unter Einsatz von Elektronenstrahl-Belichtungsverfahren kann dieser Abstand auf 2 bis 3 μm verringert werden.

Die Erfindung, wie sie in den Ansprüchen gekennzeichnet ist, löst die Aufgabe, eine weitere Verringerung des Abstandes zwischen Basiskontakt und Emitterkontakt und daraus resultierend eine Verbesserung der Schaltzeiten zu erzielen.

Die durch die Erfindung erreichten Vorteile sind im wesentlichen darin zu sehen, dass eine weitere Verringerung des Abstandes zwischen Basiskontakt und Emitterkontakt auf Werte kleiner etwa 0,5 μm erzielt wird. Damit einher geht eine Verbesserung der Schaltzeiten von etwa 400 bis 500 ps bei den konventionellen Bauelementen auf Werte von kleiner 150 ps, die nunmehr erreichbar sind.

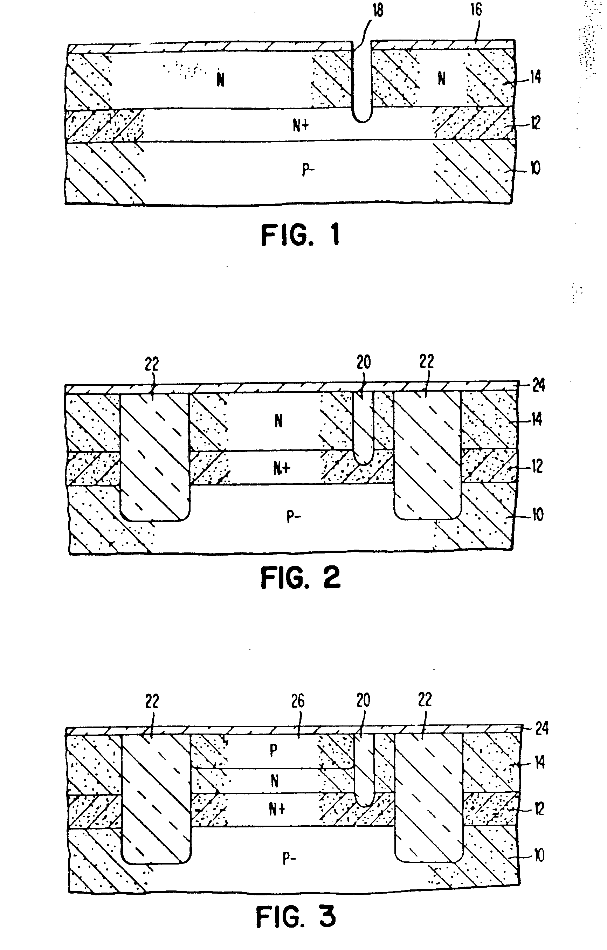

Im folgenden wird die Erfindung an Hand von lediglich einen Ausführungsweg darstellenden Zeichnungen entsprechend den Figuren 1 bis 9 näher erläutert.

Die an Hand der Figuren 1 bis 9 veranschaulichte Folge von Herstellungsschritten geht von einem Wafer bzw. Substrat 10 aus P-leitendem einkristallinen Silicium aus und führt in dem gewählten Ausführungsbeispiel zu einer NPN-Bipolartransistorstruktur. Festzuhalten ist in diesem Zusammenhang, dass die jeweiligen Leitungstypen lediglich zur Erläuterung eines Beispieles dienen und natürlich auch im Rahmen der Erfindung die entgegengesetzten Leitungstypen gewählt werden können. In gleicher Weise kann die Dotierungskonzentration gegenüber den im Ausführungsbeispiel angenommenen Werten erhöht oder abgesenkt werden. Ein solches Substrat 10 kann beispielsweise durch Ziehen eines einkristallinen Stabes aus einer geeigneten Schmelze erhalten werden, die ein P-leitendes Material, z.B. Bor, enthält und bei der ein Keimkristall mit einer kristallographischen ⟨100⟩-Orientierung eingesetzt wird. Der daraus resultierende Stab wird anschliessend in sehr dünne Scheiben (Wafer) geschnitten, die ihrerseits wiederum die genannte kristallographische Orientierung hinsichtlich ihrer Oberfläche aufweisen. Ein solches P-leitendes Siliciumsubstrat weist vorzugsweise einen spezifischen Widerstandswert von etwa 10 bis 20 $\Omega$ cm auf.

Unter Bezugnahme auf Fig. 1 wird anschliessend im Substrat 10 ein (nicht gezeigtes) Gebiet mit gegenüber dem Substrat unterschiedlichem Leitungstyp ausgebildet. Dieses Gebiet wird vorzugsweise mittels Ionenimplantation hergestellt; es kann alternativ jedoch auch mittels konventioneller Diffusionsverfahren gebildet werden. Im Falle eines Siliciumsubstrats wird dazu zunächst eine Isolierschicht aus Siliciumdioxid auf der Halbleiteroberfläche mittels thermischer Oxidation ausgebildet. Die Dicke dieser Siliciumdioxidschicht beträgt vorzugsweise 25 nm. Eine Schicht solcher Dicke wirkt bei der anschliessenden Ionenimplantation als Abschirmung bzw. Maske. Die oxidierte Siliciumscheibe wird dann in eine Implantationskammer eingebracht und einer Bestrahlung mit Arsenionen bei 50 keV und einer Dosierung von $10^{16}$ cm$^{-2}$ über eine so ausreichende Zeitspanne unterworfen, dass eine N$^+$-dotierte (nicht dargestellte) Schicht erhalten wird. Darauf wird die Anordnung aus der Implantationskammer entnommen und in einen geeigneten Ofen eingebracht, in dem die implantierte Schicht einer Wärmebehandlung bei etwa 110°C unterworfen wird: beispielsweise für etwa 5 Min. in Sauerstoff, anschliessend für etwa 70 Min. in Argon, dann für etwa 55 Min. in Dampf und noch einmal für etwa 5 Min. in Sauerstoff. Die Auswirkung dieser Wärmebehandlung besteht darin, dass das Arsen weiter in das P$^-$-leitende Substrat eingetrieben wird. Die Siliciumdioxidschicht an der Oberfläche wird schliesslich mittels geeigneter Ätzverfahren entfernt.

Um auf der Oberfläche des Substrats 10 eine Epitaxieschicht 14 aufwachsen zu lassen, wird die Anordnung darauf in eine entsprechende Apparatur eingesetzt. Die Epitaxieschicht kann in jeder gewünschten Dicke hergestellt werden, wobei jedoch im Rahmen der in vorliegender Erfindung angestrebten Hochgeschwindigkeits-Bauelemente die Dicke kleiner als etwa 2 µm sein sollte. Die bevorzugte Dicke der Epitaxieschicht ist etwa 1,2 µm. Die Epitaxieschicht 14 lässt man auf dem Substrat 10 mittels konventioneller Verfahrensschritte aufwachsen, z.B. unter Verwendung von Mischungen aus SiCl$_4$/H$_2$ oder SiH$_4$/H$_2$ bei etwa 1000 bis 1200°C. Beim Aufwachsen der Epitaxieschicht wandern Dotierungsstoffe auf der oben genannten N$^+$-Schicht in die Epitaxieschicht aus, so dass sich resultierend die in Fig. 1 mit 12 bezeichnete N$^+$-Schicht ergibt, die als Subkollektor für die im Rahmen dieses Ausführungsbeispiels beschriebene NPN-Transistorstruktur dient.

Die nächsten Verfahrensschritte dienen zum Ätzen der Siliciumstruktur mittels sog. reaktiver Ionenätzung bzw. Plasmaätzung. Dazu wird zunächst in konventioneller Weise entweder thermisch bei einer Temperatur von 970°C in nasser oder trockener Sauerstoffatmosphäre oder durch chemische Niederschlagsverfahren eine Siliciumdioxidschicht 16 ausgebildet. Es können auch andere Materialien für die Maskierungsschicht benutzt werden, z.B. Siliciumnitrid und Aluminiumoxid oder Mischformen daraus. Bevorzugt wird eine 0,3 µm dicke Siliciumdioxidschicht, die mittels chemischer Niederschlagung aus der Gasphase unter Verwendung einer Mischung aus Silan und N$_2$O bei 800°C in einer Stickstoffatmosphäre gebildet wird. In einer sich daran anschliessenden ersten Verfahrensschrittfolge werden nun durch die Basis bis in den Subkollektor hineinreichende Isolationsgebiete hergestellt. Dazu werden mittels konventioneller Photolithographie- und Ätzverfahren in der Siliciumdioxidschicht 16 Öffnungen an den Stellen gebildet, an denen die genannten Isolationsgebiete vorgesehen werden sollen. Die Anordnung wird dann in eine Einrichtung zum reaktiven Ionenätzen eingebracht und dort behandelt. Bezüglich weiterer Einzelheiten dieses reaktiven Ionenätzens wird auf die DE-OS 26 17 483 Bezug genommen. Das HF-Plasma besteht aus reaktives Chlor, Brom oder Jod enthaltendem Material. Die Dicke der Maskierungsschicht liegt zwischen etwa 200 bis 2000 nm, wobei die exakte Dicke jeweils von der Tiefenerstreckung der Ätzgrube im Silicium abhängt. In der genannten Patentanmeldung findet sich auch eine genaue Beschreibung der HF-Entladeapparatur. Die Plasmaatmosphäre ist vorzugsweise eine Kombination aus einem Edelgas, z.B. Argon, und einem Fluor enthaltenden Material. Die zugeführte Leistung zur Erzielung einer für Silicium ausreichenden Ätzrate liegt bei etwa 0,1 bis 0,75 W/cm$^2$ und wird von einer HF-Spannungsquelle geliefert. Das erstrebte Ergebnis dieses Ätzvorganges ist eine Öffnung der in Fig. 1 mit 18 bezeichneten Art, wobei diese Öffnung bzw. dieser Kanal wenigstens teilweise in das N$^+$-Gebiet 12 hineinreicht.

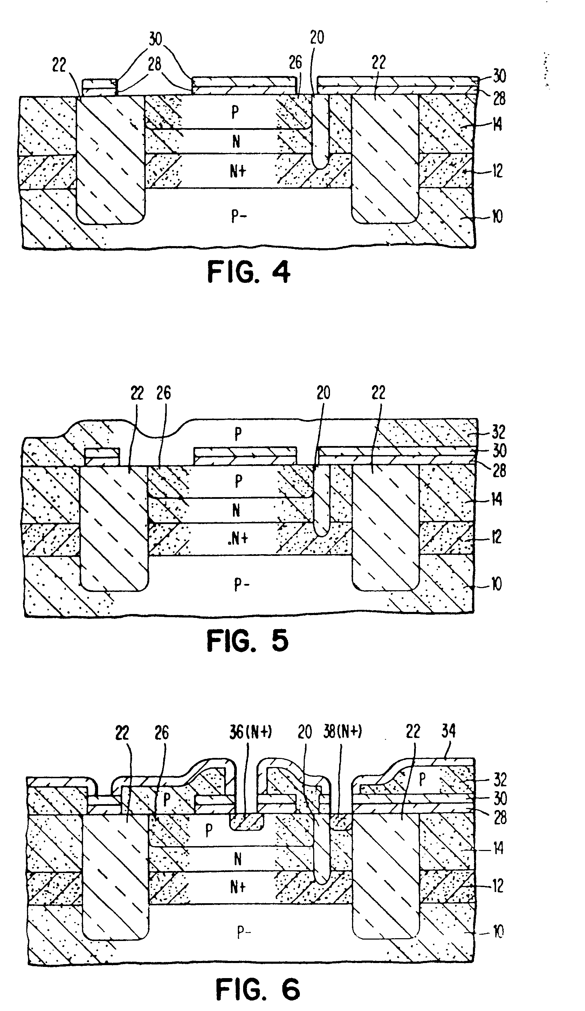

Unter Bezugnahme auf Fig. 2 schliesst sich daran ein zweiter Plasmaätzschritt zur Bildung von Isolationsgebieten zwischen den einkristallinen Siliciumbereichen an. Dazu wird mittels konventioneller Ätzverfahren die Siliciumdioxidschicht 16 entfernt und durch eine andere Oberflächenbeschichtung mit Siliciumdioxid ersetzt, die vorzugsweise durch pyrolythischen Niederschlag unter Verwendung einer Mischung aus Silan und N$_2$O in einer N$_2$-Atmosphäre bei 800°C mit einer Dicke von 0,6 bis 0,8 µm erzeugt wird. Bei diesem Vorgang wird die Öffnung 18 mit dem pyrolythischen Siliciumdioxid aufgefüllt und bildet das mit 20 bezeichnete Isolationsgebiet.

Danach werden erneut in der Halbleiteranordnung Öffnungen mittels konventioneller Photolithographie- und Ätzverfahren an den Stellen hergestellt, an denen die gewünschten dielektrischen Isolationsgebiete für die Isolation einkristalliner Siliciumbereiche vorgesehen sind. Unterzieht man die Halbleiteranordnung nun erneut einer Plasmaätzbehandlung der oben beschriebenen Art, erfolgt durch die Öffnungen eine Ätzung des Siliciums bis zur gewünschten Tiefe. Vorzugsweise erstrecken sich die Öffnungen durch das $N^+$-Gebiet 12 hindurch in das Substrat 10. Bezüglich weiterer Einzelheiten des Ätzens dieser Öffnungen wird auf die US-PS 4104 086 Bezug genommen.

Der nächste Schritt in dem hier behandelten Verfahrensablauf besteht in der thermischen Oxidation der so gebildeten Öffnungen oder Kanäle, indem man den Halbleiterkörper beispielsweise bei 970°C einer nassen Sauerstoffatmosphäre aussetzt.

Um innerhalb der Öffnung bzw. dem Kanal die Siliciumdioxidschicht mit einer bevorzugten Dikke von 50 bis 200 nm auszubilden, beträgt die Behandlungsdauer etwa 10 bis 30 Min. Durch das thermisch gebildete Oxid sollen gute Grenzflächeneigenschaften des Siliciumdioxids gewährleistet werden, was gewöhnlich mit chemisch niedergeschlagenem dielektrischem Material nicht befriedigend genug erreicht wird. Die Bildung des dielektrischen Materials mit hoher Qualität ist deshalb nötig, um ein direktes Angrenzen der Diffusionsübergänge bzw. der Dotierungsgebiete an die dielektrischen Isolationsgebiete zulassen zu können. Die letztlich erfolgende vollständige Auffüllung der Öffnung mit einem geeigneten dielektrischen Material wird mittels Niederschlags von Siliciumdioxid vorgenommen, so dass schliesslich die mit 22 bezeichneten aufgefüllten Öffnungen bzw. Gräben verbleiben.

In manchen Fällen kann es von Vorteil sein, vor dem pyrolythischen Niederschlagen eine Ionenimplantation von Borionen durch die den Boden der Isolationsgräben bedeckende Oxidschicht vorzunehmen. Dadurch werden unterhalb der Isolationsgebiete $P^+$-dotierte Gebiete erzeugt, wodurch eine Inversion des $P^-$-Materials unterhalb der Isolationsgebiete in N-leitendes Material verhindert wird.

Das pyrolythische Siliciumdioxid wird mit einer vorzugsweisen Dicke von 2 bis 3 µm niedergeschlagen. Der bevorzugte Auffüllprozess besteht in einem chemischen Niederschlagen von Siliciumdioxid aus der Gasphase unter Verwendung von Gasgemischen aus $CO_2/SiH_4/N_4$ oder $N_2O/SIH_4/N_2$ im Temperaturbereich zwischen 800 und 1000°C. Die typische Niederschlagsrate liegt dabei etwa in der Grössenordnung von 5 bis 10 nm pro Min. Als nächster Verfahrensschritt folgt das Beseitigen des überschüssigen Siliciumdioxids von der Oberfläche mittels reaktiver Ionenätzung. Bezüglich der Einzelheiten dieses Verfahrensschrittes kann auf die oben erwähnten Ausführungen verwiesen werden. In Fig. 2 ist die resultierende Halbleiteranordnung mit der vollständigen Isolation der jeweiligen einkristallinen Siliciumbereiche mittels dielektrischer Isolationsgebiete 22 veranschaulicht. Um die Siliciumdioxidschicht 24 auf der Halbleiteroberfläche auf die gewünschte Dicke von etwa 0,08 µm zu bringen, erfolgt eine entsprechende Nachoxidation.

Im Zusammenhang mit Fig. 3 ist die Bildung des Basisgebietes 26 innerhalb des isolierten einkristallinen Siliciumbereiches illustriert. Dazu wird mittels geeigneter Photolithographie- und Ätzverfahren in der Siliciumdioxidschicht 24 die zugehörige Basisöffnung hergestellt, innerhalb der die Siliciumoberfläche freiliegt. Die Anordnung wird dann in eine Implantationskammer eingebracht und eine Bor-Ionenimplantation bei etwa 100 keV mit einer Dosierung von ungefähr $1,5 \times 10^{14}$ Ionen/$cm^2$ vorgenommen. Dieser Verfahrensschritt resultiert in der Bildung des Basisgebietes 26. Vorzugsweise grenzt das Basisgebiet direkt an die dielektrischen Isolationsgebiete. Die Siliciumdioxidschicht 24 wird dann abgeätzt, wobei ein geeignetes Verfahren in der Verwendung von $CF_4$ bei einem Gasdruck von 10 bis 70 µm mit Durchflussraten von 2 bis 50 $cm^3$/Min. liegt. Die HF-Leistung kann dabei von etwa 0,1 $W/cm^2$ ausgehen.

Als nächstes wird, wie aus Fig. 4 ersichtlich ist, erneut mittels chemischen Niederschlags aus der Gasphase oder thermisch eine Siliciumdioxidschicht 28 mit einer vorzugsweisen Dicke von ungefähr 30 nm auf der Siliciumoberfläche erzeugt. Darüber wird eine Schicht 30 aus Siliciumnitrid gebildet, die ebenfalls vorzugsweise 30 nm dick ist. Diese Siliciumnitridschicht wird mittels eines HF-Sputterverfahrens oder vorzugsweise durch pyrolythischen Niederschlag aus einer Mischung von Silan und Ammoniak in einer Stickstoffatmosphäre bei 800°C gebildet. Es sind auch andere Kombinationen verschiedener dielektrischer Materialien ausser Siliciumdioxid und Siliciumnitrid verwendbar, beispielsweise Aluminiumoxid, dickes Siliciumdioxid und/oder Kombinationen aus Siliciumdioxid und Siliciumnitrid. Durch Anwendung üblicher Photolithographie- und Ätzverfahren werden einzelne Bereiche der Siliciumdioxidschicht 28 sowie der Siliciumnitridschicht 30 von der Halbleiteroberfläche entfernt. Diejenigen Halbleitergebiete, die danach als mit der Siliciumdioxidschicht 28 sowie mit der Siliciumnitridschicht 30 maskierte Gebiete verbleiben, sind die für Emitter und Kollektoranschlussgebiete vorgesehenen Halbleiterbereiche.

Unter Verwendung einer Mischung aus Silan und Diboran in einer Wasserstoffatmosphäre bei 800°C wird über der gesamten Oberfläche der Halbleiteranordnung eine Schicht 32 aus P-dotiertem Silicium niedergeschlagen. Es können auch andere P-leitende Dotierungsstoffe alternativ Anwendung finden. Die Dicke dieser Siliciumschicht sollte zwischen etwa 100 und 1000 nm und vorzugsweise bei 500 nm liegen. Bei Dicken grösser als 1000 nm treten Ebenheitsprobleme auf, die die Fabrikation hochintegrierter Halbleiterschaltungen erschweren. Bei Schichtdicken kleiner 100 nm wird der Widerstandseinfluss der Polysiliciumschicht so erheblich, dass dadurch die geforderten Bauelementeigenschaften nachteilig beeinflusst werden. Die bevorzugte Dotierungskonzentration liegt zwischen etwa $10^{19}$ und $10^{21}$ Atomen/cm³. Mittels erneutem Einsatz von Photolithographie- und Ätztechniken werden über etwaigen Schottky-Kontakten, Emitter- sowie Kollektoranschlussgebieten die jeweiligen Bereiche der Siliciumschicht 32 entfernt. Die Siliciumschicht 32 wird schliesslich mit einer ungefähr 200 nm dicken Siliciumdioxidschicht 34 überdeckt.

Auf die Oberfläche der Schicht 34 wird dann eine Photolackschicht aufgebracht, entwickelt und ausgehärtet, um somit eine Maskierungsschicht für das Plasmaätzen der beiden 30 nm dicken Schichten 30 und 28 aus Siliciumnitrid und Siliciumdioxid über den Emitter- und Anschlussgebieten bereitzustellen. Die reaktive Ionenätzung erfolgt in einer Einrichtung vom Diodentyp mit $CF_4$-Gas bei einem Druck von 30 bis 40 μm, einer Durchflussrate von ungefähr 2 bis 3 cm³/Min. und einer Leistungsdichte von ungefähr 0,3 W/cm² bei Raumtemperatur.

Die Anordnung wird anschliessend in eine geeignete Ionenimplantationseinrichtung eingebracht, in der die Implantationen für Emitter und Kollektoranschlussgebiete vorgenommen werden. Bevorzugtes Implantationsmaterial ist dabei Arsen mit einer Dosierung von $10^{15}$ Atomen/cm² bei einer Implantationsenergie von etwa 40 keV. Die daraus resultierende Struktur ist in Fig. 6 gezeigt, worin der Emitter mit 36 und das Kollektoranschlussgebiet mit 38 bezeichnet ist. In einer Heizeinrichtung wird die Anordnung anschliessend bei erhöhter Temperatur, z.B. bei 1000°C, für etwa 5 Min. in Sauerstoff und anschliessend für etwa 30 Min. in Stickstoff behandelt. Dadurch erfolgt das endgültige Eintreiben der Dotierungsstoffe in den mit 36 und 38 bezeichneten Gebieten.

Mittels konventioneller Photolithographieschritte gefolgt von einem Plasmaätzschritt wird anschliessend ein Kontaktloch in der Siliciumdioxidschicht 34 geöffnet, wodurch an dieser Stelle das zu kontaktierende P-dotierte Silicium im Bereich 40 freigelegt wird. Der genannte reaktive Ätzschritt des Siliciumdioxids erfolgt wieder in einem $CF_4$-Gas bei 30 bis 40 μm Druck und einer Durchflussrate von ungefähr 2 bis 3 cm³/Min.

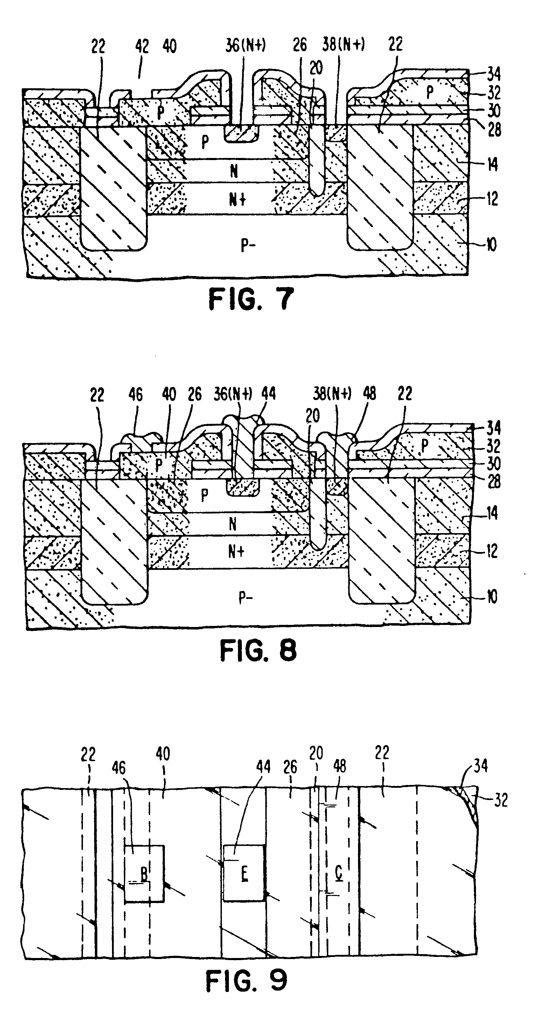

Auf die Oberfläche der Halbleiteranordnung wird dann ein geeignetes Kontaktmetall aufgedampft oder in anderer Weise niedergeschlagen. Als typisches Kontaktmaterial ist Aluminium oder Aluminium-Kupfer anzusehen. Es können aber auch andere bekannte Materialien Verwendung finden, z.B. Platin, Palladium, Molybdän usw. Die jeweils gewünschte Leiterzugausbildung auf der Halbleiteroberfläche erfolgt dann wiederum in bekannter Photolithographie- und Ätztechnik. Fig. 8 zeigt die vollständige NPN-Transistorstruktur, die mit dem beschriebenen Prozess erhalten wird. Darin sind der Emitterkontakt mit 44, der Kontakt zum Basisgebiet mit 40, der Basiskontakt in der zweiten (Leitungs-) Ebene mit 46 und der Kollektoranschlusskontakt mit 48 bezeichnet. Fig. 9 zeigt schliesslich die zu Fig. 8 gehörige Draufsicht auf die Halbleiteranordnung.

Der wesentliche Vorteil der so hergestellten und aufgebauten Strukturen liegt darin, dass der Abstand zwischen Basiskontakt und Emitterkontakt kleiner als 0,5 μm gemacht werden kann. Das wiederum beruht auf der Verwendung von dotiertem Polysilicium als Kontaktmaterial, das vorzugsweise den Emitterkontakt umschliesst. Mit dem genannten Aufbau geht letztlich eine bedeutsame Verringerung des von dem Bauelement beanspruchten Flächenbedarfs einher. Der Schaltungsentwurf unter Verwendung derartiger Bauelemente ist zudem relativ einfach, da die Basis-Kontaktmetallisierung parallel zur Emitter- und Kollektor-Metallisierung liegt. Der durch das Polysilicium gebildete Basiskontakt umgibt allseitig den Emitter und gewährleistet dadurch ein in allen Richtungen gleichmässiges Injektionsverhalten bei zudem gesteigertem Emitterwirkungsgrad. Weiterhin stellt die hochdotierte Polysiliciumschicht bereits eine Diffusionsquelle für den extrinsischen Basisbereich dar, so dass eine solche extrinsische Basisdiffusion, die bei mit flachen Übergängen ausgestatteten Transistorstrukturen ohnehin schwierig ist, entfallen kann. Für die Abmessungen des Emitters (Breite und Länge) ergeben sich schliesslich Werte von kleiner 2 μm sowie für den Emitterkontakt–Basiskontaktabstand ebenfalls der bereits genannte Wert von kleiner 0,5 μm.

**Patentansprüche**

1. Integrierte Halbleiteranordnung für eine Bauelementstruktur mit kleinem Basiskontakt-Emitterkontaktabstand mit in einem Silicium-Halbleiterkörper angeordneten und gegeneinander durch Isolationsgebiete (22) getrennten einkristallinen Halbleiterbereichen, von denen mindestens einer einen vergrabenen Subkollektor (12) aufweist, mit einem in einem derartigen einkristallinen Halbleiterbereich eine Verbindung von der Halbleiteroberfläche zum Subkollektor (12) herstellenden Kollektoranschlussgebiet (38), einem von dem Kollektoranschlussgebiet (38) beabstandet angeordneten Basisgebiet (26) mit einem darin liegenden und an die Halbleiteroberfläche reichenden Emittergebiet (36) sowie mit einer auf Oberflächenteilen dieser einkristallinen Halbleiterbereiche angeordneten Schichtstruktur aus einer ersten (28) und aus einer zweiten (30) Isolierschicht sowie aus einer darüberliegenden dotierten polykristallinen Siliciumschicht (32), die mit einer dritten Isolierschicht (34) bedeckt ist, dadurch gekennzeichnet, dass die polykristalline Siliciumschicht (32) Öffnungen an den für Emitter (36) und Kollektoranschlussgebiete (38) vorgesehenen Stellen und einen durch die dritte Isolierschicht (34) von einem Emitterkontakt (44) getrennten Bereich (40) zur Herstellung eines nichtgleichrichtenden Kontaktes zum Basisgebiet (26) aufweist.

2. Integrierte Halbleiteranordnung nach Anspruch 1, dadurch gekennzeichnet, dass der das Basisgebiet (26) kontaktierende Bereich (40) der polykristallinen Siliciumschicht (32) den Anschlusskontakt (44) des Emitters (36) umschliesst.

3. Integrierte Halbleiteranordnung nach Anspruch 1 oder 2, dadurch gekennzeichnet, dass die Isolationsgebiete (22) aus einem dielektrischen Material, vorzugsweise Siliciumdioxid, bestehen.

4. Integrierte Halbleiteranordnung nach einem der Ansprüche 1 bis 3, dadurch gekennzeichnet, dass im Bereich des Abstandes zwischen dem Basisgebiet (26) und dem das Kollektoranschlussgebiet (38) enthaltenden Teil des Halbleiterkörpers ein weiteres Gebiet (20) aus dielektrischem Material angeordnet ist.

5. Integrierte Halbleiteranordnung nach Anspruch 4, dadurch gekennzeichnet, dass das Basisgebiet (26) seitlich unmittelbar von den Gebieten (20, 22) aus dielektrischem Material begrenzt ist.

6. Integrierte Halbleiteranordnung nach einem der Ansprüche 1 bis 5, dadurch gekennzeichnet, dass der aus polykristallinem Silicium bestehende Bereich (40) für den Kontakt zum Basisgebiet (26) eine Dicke von etwa 100 bis 1000 nm und eine Bor-Dotierungskonzentration von etwa $10^{19}$ bis $10^{21}/cm^3$ aufweist.

7. Integrierte Halbleiteranordnung nach einem der Ansprüche 1 bis 6, gekennzeichnet durch eine Transistorstruktur, vorzugsweise vom NPN-Typ, mit Emitter-Kantenabmessungen kleiner $2 \times 2$ μm und einem Basiskontakt-Emitterkontaktabstand kleiner etwa 0,5 μm.

8. Verfahren zur Herstellung einer integrierten Halbleiteranordnung für eine Bauelementstruktur mit kleinem Basiskontakt-Emitterkontaktabstand nach einem der Ansprüche 1 bis 7, gekennzeichnet durch folgende Verfahrensschritte:
– in einem Silicium-Halbleiterkörper werden gegeneinander durch Gebiete (22, 20) aus dielektrischem Material isolierte einkristalline Halbleiterbereiche und in einigen dieser Halbleiterbereiche mit einem vergrabenen Subkollektorbereich (12) jeweils ein Basisgebiet (26) ausgebildet;
– an den für Emitter (36) und Kollektoranschlussgebiete (38) vorgesehenen Stellen wird die Halbleiteroberfläche mit einer Maskierungsschicht aus der ersten und zweiten Isolierschicht (28, 30) von unterschiedlichem dielektrischem Material bedeckt, die an den für Basisgebiete vorgesehenen Stellen Öffnungen aufweist;
– auf die Oberfläche wird eine derart dotierte polykristalline Siliciumschicht (32) aufgebracht, dass dadurch ein nicht-gleichrichtender Kontakt (40) zum jeweiligen Basisgebiet (26) gebildet wird;
– die polykristalline Siliciumschicht (32) wird an den für Emitter (36) und Kollektoranschlussgebiete (38) vorgesehenen Stellen entfernt, und ihre resultierende Oberfläche mit der dritten Isolierschicht (34) überzogen;
– nach dem selektiven Freilegen der Halbleiteroberfläche durch Entfernung der den Halbleiterkörper bedeckenden ersten und zweiten Isolierschicht (28, 30) an den für Emitter und Kollektoranschlussgebiete vorgesehenen Stellen erfolgt die Dotierungsausbildung für den Emitter (36) im Basisgebiet (26) sowie für das Kollektoranschlussgebiet (38) und anschliessend in an sich bekannter Weise die Herstellung von elektrischen Anschlusskontakten (44, 48, 46) für den Emitter (36) und das Kollektoranschlussgebiet (38) sowie für den das Basisgebiet (26) kontaktierenden polykristallinen Siliciumschichtbereich (40).

9. Verfahren nach Anspruch 8, dadurch gekennzeichnet, dass die Maskierungsschicht aus einer ersten Schicht (28) aus Siliciumdioxid und einer zweiten Schicht (30) aus Siliciumnitrid gebildet wird.

**Claims**

1. An integrated semiconductor device providing a component structure with a small base contact/emitter contact spacing comprising: a plurality of monocrystalline semiconductor regions arranged in a silicon semiconductor body and isolated from one another by isolation regions (22), at least one of said monocrystalline semiconductor regions having a buried subcollector (12), a collector reach-through region (38) connecting the semiconductor surface to the subcollector (12) in said at least one monocrystalline semiconductor region, a base region (26), spaced from said collector reach-through region (38), with an emitter region (36) arranged therein and extending up to the semiconductor surface, and a layer structure arranged on the surface of each of said monocrystalline semiconductor regions, which layer structure comprises first (28) and second (30) insulator layers, and a doped polycrystalline silicon layer (32) arranged thereover which is covered by a third insulator layer (34), characterized in that: said polycrystalline silicon layer (32) has openings in the regions designated to be the emitter (36) and the collector reach-through regions (38), and has a region (40) insulated from an emitter contact (44) by said third insulator layer (34) for forming an ohmic contact to the base region (26).

2. Integrated semiconductor device according to claim 1, characterized in that the region (40) of the polycrystalline silicon layer (32) contacting the base region (26) surrounds the contact (44) of the emitter (36).

3. Integrated semiconductor device according to claim 1 or 2, characterized in that the isolation regions (22) consist of dielectric material, preferably silicon dioxide.

4. Integrated semiconductor device according to any one of the claims 1 to 3, characterized in that the part of the semiconductor body in the region between the base region (36) and the collector reach-through region (38) has a further region (20) of dielectric material.

5. Integrated semiconductor device according to claim 4, characterized in that the regions (20, 22) of dielectric material laterally about the base region (26).

6. Integrated semiconductor device according to any one of the claims 1 to 5, characterized in that the area (40) of polycrystalline silicon for contacting the base region (26) has a thickness of about 100 to 1000 nm and a boron doping concentration of between about $10^{19}$ to $10^{21}/cm^3$.

7. Integrated semiconductor device according to any one of the claims 1 to 6, characterized by a transistor structure, preferably of the NPN type, with emitter edge dimensions of less than $2\times2$ μm and a base contact/emitter contact spacing of less than about 0.5 μm.

8. Method for fabricating an integrated semiconductor device for a component structure with a small base contact/emitter contact spacing according to anyone of the claims 1 to 7, characterized by the following steps: forming in a silicon semiconductor body monocrystalline semiconductor regions isolated from one another by regions (22, 20) of dielectric material and one base region each (26) in several of said semiconductor regions with a buried subcollector region (12); covering the semiconductor surface in the regions designated to be the emitter (36) and the collector reach-through regions (38) with a masking layer consisting of the first and the second insulator layer (28, 30) of different dielectric material, which has openings in the regions designated to be the base regions; applying to the surface a polycrystalline silicon layer (32) thus doped so that an ohmic contact (40) is formed to the respective base region (26); removing the polycrystalline silicon layer (32) in the regions designated to be the emitter (36) and the collector reach-through regions (38), and covering the resulting surface with a third insulator layer (34); doping the emitter (36) in the base region (26) as well as the collector reach-through region (38) after the semiconductor surface has been selectively bared by removing the first and the second insulator layer (28, 30) covering the semiconductor body in the regions designated to be the emitter and the collector reach-through regions, and subsequently producing in a known manner the electrical contacts (44, 48, 46) for the emitter (36) and the collector reach-through region (38) as well as for the polycrystalline silicon layer region (40) contacting the base region (26).

9. Method according to claim 8, characterized in that the masking layer consists of a first layer (28) of silicon dioxide and a second layer (30) of silicon nitride.

## Revendications

1. Dispositif semi-conducteur pour une structure de composant ayant une faible espacement entre le contact de base et le contact d'émetteur, comportant: des régions semi-conductrices monocristallines dans un substrat semi-conducteur en silicium, séparées les unes des autres par des régions d'isolement (22); au moins une desdites régions semi-conductrices ayant un sous-collecteur enterré (12), une région de traversée de collecteur (38) établissant dans cette région semi-conductrice monocristalline une connexion entre la surface semi-conductrice et le sous-collecteur (12); une région de base (26), espacée de la région de traversée de collecteur (38) et dans la région base une région d'émetteur (36) s'étendant jusqu'à la surface smi-conductrice; une structure de couches disposée sur des parties de la surface desdites régions semi-conductrices monocristallines, qui comporte successivement une première (28) et une seconde (30) couches d'isolement, une couche de silicium polycristallin dopée (30) qui est recouverte d'une troisième couche d'isolement (34); dispositif caractérisé en ce que la couche de silicium polycristallin (32) comporte des ouvertures aux emplacements prévus pour les régions d'émetteur (36) et de traversée de collecteur (38) ainsi qu'une région (40) séparée par la couche d'isolement (34) du contact d'émetteur (44) pour produire un contact ohmique avec la région de base (26).

2. Dispositif semi-conducteur intégré selon la revendication 1, caractérisé en ce que la région (40) de la couche de silicium polycristallin (32) qui établit le contact avec la région de base (26) entoure le contact de traversée (44) de l'émetteur (36).

3. Dispositif semi-conducteur intégré selon la revendication 1 ou 2, caractérisé en ce que les régions d'isolement (22) sont composées d'un matériau diélectrique, de préférence du dioxyde de silicium.

4. Dispositif semi-conducteur intégré selon l'une quelconque des revendications 1 à 3, caractérisé en ce que la partie du semi-conducteur entre la région de base (36) et la région de traversée de collecteur (38) comporte une autre région (20) de matériau diélectrique.

5. Dispositif semi-conducteur intégré selon la revendication 4, caractérisé en ce que la région de base (26) est délimitée latéralement par les régions (20, 22) de matériau diélectrique.

6. Dispositif semi-conducteur intégré selon l'une quelconque des revendications 1 à 5, caractérisé en ce que la région (40) composée de silicium polycristallin a, pour le contact avec la région de base (26), une épaisseur d'environ 100 à 1000 nm et une concentration de dopage de bore d'environ $10^{19}$ à $10^{21}/cm^3$.

7. Dispositif semi-conducteur intégré selon l'une quelconque des revendications 1 à 6, caractérisé par une structure de transistor, de préférence du type NPN, ayant des dimensions de bord d'émetteur inférieures à $2\times2$μm et un espacement entre le contact de base et le contact d'émetteur inférieur à environ 0,5 μm.

8. Procédé pour fabriquer un dispositif semi-conducteur pour une structure de composant ayant un espacement réduit entre le contact de base et le contact d'émetteur tel que décrit selon l'une quelconque des revendications 1 à 7, caractérisé en ce qu'il comporte les étapes suivantes:
dans un substrat semi-conducteur de silicium on forme des régions semi-conductrices monocristallines isolées les unes des autres par des régions (22, 20) d'un matériau diélectrique, ainsi qu'une région de base (26) dans certaines de ces régions semi-conductrices qui comportent une région de sous-collecteur enterré (12);

aux emplacements prévus pour l'émetteur (36) et les régions de traversée de collecteur (38) on dépose sur la surface semi-conductrice une couche de masquage comportant une première et seconde couches d'isolement (28, 30) d'un matériau diélectrique différent, ladite couche ayant des ouvertures aux emplacements prévus pour les régions de base;

sur la surface on dépose une couche de silicium polycristallin dopée (32) de telle sorte qu'on forme un contact ohmique (40) avec la région de base (26) correspondante;

on enlève la couche de silicium polycristallin (32) aux emplacements prévus pour l'émetteur (36) et les régions de traversée de collecteur (38), et on recouvre la surface ainsi obtenue avec une troisième couche d'isolement (34);

après avoir sélectivement exposé la surface semi-conductrice en enlevant les première et seconde couches d'isolement (28, 30), recouvrant le substrat semi-conducteur aux emplacements prévus pour l'émetteur et les régions de traversée de collecteur, on dope l'émetteur (36) dans la région de base (26) ainsi que la région de traversée de collecteur (38) et on produit ensuite de la façon bien connue les contacts de traversée électriques (44, 48, 46) respectivement pour l'émetteur (36), la région de traversée de collecteur (38), ainsi que pour la couche de silicium polycristallin (40) qui établit le contact avec la région de base (26).

9. Procédé selon la revendication 8, caractérisé en ce que la couche de masquage est formée d'une première couche (28) de dioxyde de silicium et d'une seconde couche (30) de nitrure de silicium.

FIG. 1

FIG. 2

FIG. 3

FIG. 4

FIG. 5

FIG. 6

FIG. 7

FIG. 8

FIG. 9